# EUROPÄISCHE PATENTSCHRIFT

(11) **EP 0 955 582 B1**
(45) Veröffentlichungstag und Bekanntmachung des Hinweises auf die Patenterteilung: **04.07.2007**
(21) Anmeldenummer: 99108882.4
(22) Anmeldetag: 05.05.1999
(51) Int. Cl.: H03M 1/12, H03K 5/13, G06F 3/05, G06F 9/46

(54) **Zeitgeber für einen A/D-Wandler**
Timer for an A/D converter
Horloge pour un convertisseur analogique-numérique

(30) Priorität: 08.05.1998 DE 19820735
(43) Veröffentlichungstag der Anmeldung: 10.11.1999
(73) Patentinhaber: Infineon Technologies AG, 81669 München (DE)
(72) Erfinder: Barrenscheen, Jens, Dr., 81669 München (DE); Frenzl, Gunther, 85635 München (DE); Rohm, Peter, 85276 Pfaffenhofen (DE)
(74) Vertreter: Jannig, Peter

(56) Entgegenhaltungen:
- US-A- 5 172 116
- US-A- 5 619 201
- US-A- 5 675 337

## Beschreibung

Die vorliegende Erfindung betrifft einen Zeitgeber für einen A/D-Wandler gemäß dem Oberbegriff des Anspruches 1.

In komplexen Applikationen müssen unterschiedliche analoge Eingangssignale zu zuvor programmierten Zeiten oder als Antwort auf verschiedene Ereignisse dem A/D-Wandler zugeführt und gewandelt werden. Die zu wandelnden Eingangssignale können von unterschiedlichen Wandler-Anforderungsquellen stammen, denen wiederum eine Vielzahl von unterschiedlichen Signalkanälen zugeordnet sind. Die Anforderungsquellen erzeugen Anforderungssignale für den A/D-Wandler, um auf diese Weise die A/D-Wandlung eines bestimmten ihrer Signalkanäle bei dem A/D-Wandler anzufordern.

Eine dieser Anforderungsquellen kann eine programmierbare Zeitgebereinheit sein, die zeitlich gesteuert Anforderungssignale für den A/D-Wandler erzeugt. Insbesondere ermöglichen diese Zeitgebereinheiten, A/D-Wandlungen periodisch anzusto-ßen. Dabei erfolgt die Synchronisierung der Anforderungen der Zeitgebereinheit mit den anderen Anforderungsquellen über sogenannte Interrupts, wobei in der Regel nach jeder Wandlung ein sogenanntes Interrupt-Flag gesetzt wird. Da jedoch die einzelnen Module eine gewisse Reaktionszeit zum Ansprechen auf gesetzte Interrupt-Flags benötigen, ist nicht stets eine exakte Synchronisierung der unterschiedlichen Anforderungsquellen gewährleistet.

Des weiteren muß bei der Anbindung eines Zeitgebers an einen A/D-Wandler, der analoge Eingangssignale abtastet, d. h. äquidistant erfaßt und wandelt, darauf geachtet werden, daß keine Wandlung des A/D-Wandlers zu einem Zeitpunkt aktiv ist, zu dem der Zeitgeber eine neue Wandlung anfordert. Eine derartige Synchronisierung ist für einige Applikationen von größter Wichtigkeit.

Der vorliegenden Erfindung liegt daher die Aufgabe zugrunde, einen Zeitgeber für einen A/D-Wandler zu schaffen, der die zuvor erwähnten Probleme beseitigt und eine zeitlich synchronisierte Verarbeitung von seinen Anforderungssignalen ermöglicht.

Diese Aufgabe wird gemäß der vorliegenden Erfindung durch einen Zeitgeber mit den Merkmalen des Anspruchs 1 gelöst. Die Unteransprüche definieren bevorzugte und vorteilhafte Ausgestaltungen der vorliegenden Erfindung, die ihrerseits zu einer möglichst einfachen Ausgestaltung des erfindungsgemäßen Zeitgebers sowie zu einer verbesserten Synchronisierung beitragen.

Gemäß der vorliegenden Erfindung wird neben dem eigentlichen Anforderungssignal des Zeitgebers ein zusätzliches Signal erzeugt, welches zusammen mit dem eigentlichen Anforderungssignal des Zeitgebers in Kombination als Anforderungssignal des Zeitgebers für eine A/D-Wandlung durch den A/D-Wandler auszuwerten ist. Dieses zusätzliche Signal wird insbesondere während einer programmierbaren Zeitspanne erzeugt, welche mindestens so lange wie die Wandlungszeit gewählt ist, welche der A/D-Wandler für eine Wandlung eines Abtastwertes eines analogen Signals benötigt.

Mit Hilfe dieses zusätzlichen Signals kann der A/D-Wandler für andere, niederpriore Wandlungen bzw. Anforderungen anderer Anforderungsquellen blockiert und somit für den Zeitgeber reserviert werden. Auf diese Weise kann zu reproduzierbaren, äquidistanten Zeitpunkten eine A/D-Wandlung eines analogen Signals des Zeitgebers angefordert und dieses analoge Signal abgetastet werden, ohne daß auf das Ende der letzten Wandlung gewartet werden müßte. Spezielle, direkte Kopplungen des Zeitgebers mit anderen Modulen oder Anforderungsquellen können erhalten bleiben, ohne daß zur Übertragung von Anforderungen Interrupts erforderlich wären.

Die Erfindung wird nachfolgend anhand eines bevorzugten Ausführungsbeispiels unter Bezugnahme auf die beigefügten Zeichnungen näher erläutert. Dabei zeigt
Fig. 1 ein vereinfachtes Blockschaltbild einer A/D-Wandleranordnung, in der ein Zeitgeber gemäß der vorliegenden Erfindung eingesetzt ist,
Fig. 2 ein vereinfachtes Blockschaltbild eines ersten Abschnitts eines bevorzugten Ausführungsbeispiels des erfindungsgemäßen Zeitgebers,
Fig. 3 ein Diagramm zur Erläuterung des in Fig. 2 dargestellten Abschnitts des erfindungsgemäßen Zeitgebers, und
Fig. 4 ein vereinfachtes Blockschaltbild eines zweiten Abschnitts des bevorzugten Ausführungsbeispiels des erfindungsgemäßen Zeitgebers.

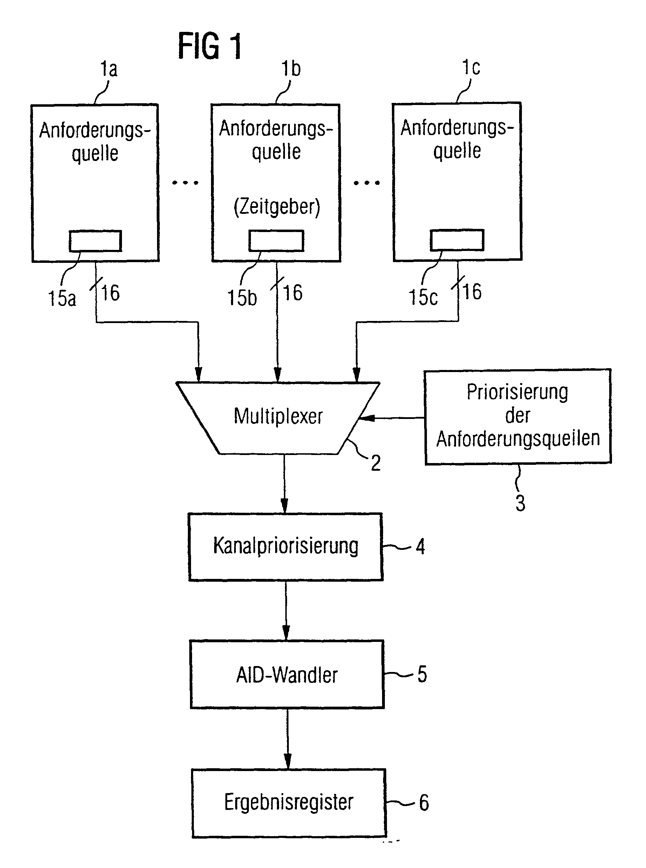

Die in Fig. 1 gezeigte A/D-Wandleranordnung umfaßt als zentrales Element einen A/D-Wandler 5, dessen Aufgabe es ist, ein ihm zugeführtes analoges Eingangssignal zu bestimmten Zeitpunkten abzutasten und das abgetastete analoge Eingangssignal in ein digitales Ausgangssignal umzuwandeln. Die digitalen Abtastwerte werden in einem Ergebnisregister 6 zur weiteren Verarbeitung gespeichert.

Das dem A/D-Wandler 5 zugeführte analoge Eingangssignal kann von unterschiedlichen Signalkanälen stammen, die wiederum unterschiedlichen Wandler-Anforderungsquellen bzw. Wandler-Anforderungseinrichtungen 1a - 1c zugeordnet sein können. Eine dieser Anforderungsquellen kann beispielsweise durch einen Zeitgeber 1b realisiert sein. Bei den ebenfalls in Fig. 1 dargestellten Anforderungsquellen 1a und 1c kann es sich hingegen um Einrichtungen handeln, die abhängig von einem externen Ereignis oder softwaremäßig gesteuert Anforderungssignale für den A/D-Wandler 5 erzeugen, um auf diese Weise eine A/D-Wandlung für einen ihrer Signalkanäle anzufordern. Des weiteren kann es sich bei diesen Anforderungsquellen um Steuerungen handeln, die in Form einer "Auto-Scan"- oder einer Warteschlangensteuerung Anforderungssignale für die ihnen jeweils zugeordneten Signalkanäle erzeugen usw. Jedem dieser Anforderungsquellen 1a - 1c ist ein Register 15a - 15c zugeordnet, in dem jeweils ein Steuerflag gesetzt wird, falls von der entsprechenden Anforderungsquelle eine Anforderung bezüglich eines der jeweiligen Anforderungsquelle zugeordneten Signalkanäle für eine A/D-Wandlung durch den A/D-Wandler 5 vorliegt. Ein zwischen die Anforderungsquellen 1a - 1c und den A/D-Wandler 5 geschalteter Multiplexer 2 hat zur Aufgabe, eine der Anforderungsquellen 1a - 1c auszuwählen und den zu wandelnden Signalkanal der ausgewählten Anforderungsquelle dem A/D-Wandler zuzuführen. Gemäß dem in Fig. 1 dargestellten Ausführungsbeispiel sind jeder Anforderungsquelle 1a - 1c 16 Signalkanäle zugeordnet, so daß die Anforderungsquellen 1a - 1c jeweils über 16 Signalleitungen mit dem Multiplexer 2 gekoppelt sind.

Da gegebenenfalls gleichzeitig mehrere Anforderungen von unterschiedlichen Anforderungsquellen vorliegen können, d. h. gleichzeitig mehrere der Steuerflags 15a - 15c gesetzt sein können, wird bei der in Fig. 1 gezeigte A/D-Wandleranordnung die zu verarbeitende Anforderung der einzelnen Anforderungsquellen 1a - 1c gemäß einer bestimmten Prioritätsregelung ausgewählt. Zu diesem Zweck ist jeder der Anforderungsquellen 1a - 1c eine bestimmte Priorität zugeordnet, wobei insbesondere jede Anforderungsquelle 1a - 1c eine individuelle Priorität aufweist. Eine Priorisierungs- bzw. Arbitrierungslogik 3 überwacht den Zustand der Steuerflags 15a - 15c der einzelnen Anforderungsquellen 1a - 1c und ermittelt bei gleichzeitiger Belegung mehrerer dieser Steuerflags 15a - 15c, d. h. bei gleichzeitigem Vorliegen von Anforderungssignalen unterschiedlicher Anforderungsquellen, diejenige Anforderungsquelle, welcher die höchste Priorität zugeordnet ist, so daß der Multiplexer 2 entsprechend zur Auswahl der Anforderungsquelle mit der höchsten Priorität angesteuert werden kann. Liegt lediglich die Anforderung einer Anforderungsquelle 1a - 1c vor, wird diese automatisch über den Multiplexer 2 zu dem A/D-Wandler 5 durchgeschaltet.

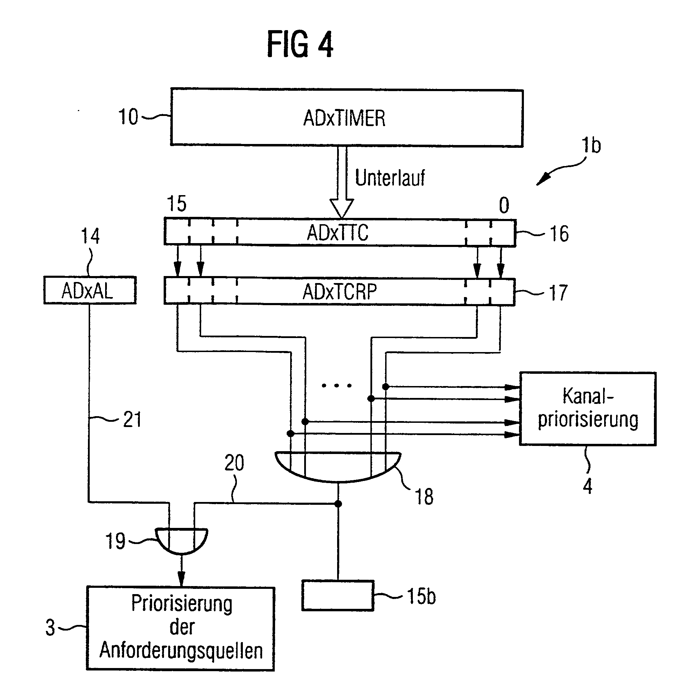

Da die von der Priorisierungslogik 3 ausgewählte Anforderungsquelle mehreren Signalkanälen zugeordnet sein kann, muß anschließend noch ermittelt werden, welcher Signalkanal dieser Anforderungsquelle tatsächlich von dem A/D-Wandler 5 gewandelt werden soll. Zu diesem Zweck ist eine Kanalpriorisierungslogik 4 vorgesehen, die - wie anhand von Fig. 4 später erläutert werden wird - beispielsweise aufgrund von Registereintragungen der ausgewählten Anforderungsquelle 1a - 1c den zu verarbeitenden Signalkanal der jeweiligen Anforderungsquelle auswählt und dem A/D-Wandler 5 zuführt.

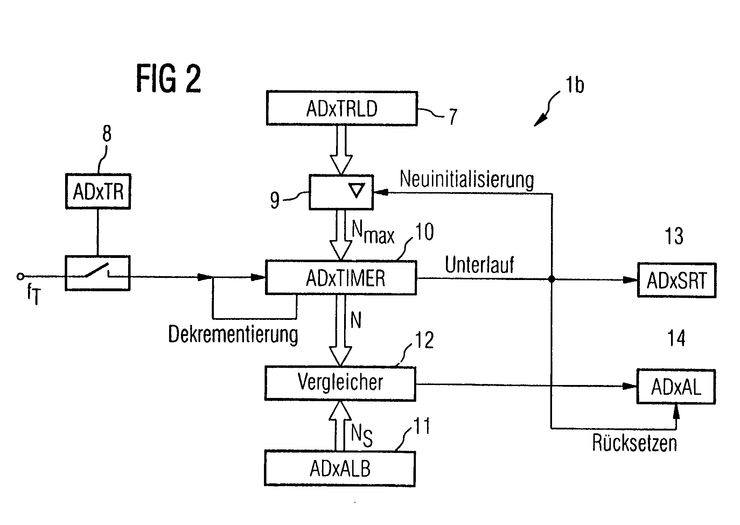

Wie bereits zuvor erläutert worden ist, kann beispielsweise die Anforderungsquelle 1b in Form einer programmierbaren Zeitgebereinheit realisiert sein, die zeitlich gesteuert periodisch Anforderungssignale für A/D-Wandlungen der ihr zugeordneten Signalkanäle erzeugt. Bei der Anbindung eines derartigen Zeitgebers an den A/D-Wandler 5 muß darauf geachtet werden, daß bei einer Abtastung der Analogsignale des Zeitgebers keine Wandlung des A/D-Wandlers 5 zu einem Zeitpunkt aktiv ist, zu dem der Zeitgeber eine neue Wandlung anfordert. Zu diesem Zweck umfaßt der Zeitgeber 1b gemäß der vorliegenden Erfindung Mittel, die eine Abtastung und A/D-Wandlung von dem Zeitgeber 1b zugeordneten analogen Signalen ohne Jitter ermöglicht. Dies soll nachfolgend näher unter Bezugnahme auf Fig. 2 - 4 erläutert werden.

Fig. 2 zeigt ein vereinfachtes Blockschaltbild eines wesentlichen Abschnitts des in Fig. 1 gezeigten Zeitgebers 1b gemäß einem bevorzugten Ausführungsbeispiel der vorliegenden Erfindung.

Wesentlicher Bestandteil des in Fig. 2 dargestellten Abschnitts ist ein Register 10, welches das eigentliche Zeitgeberregister ADxTIMER darstellt. Diesem Zeitgeberregister 10 wird durch Setzen eines in einem weiteren Register 8 abgelegten Startbilds ADxTR ein bestimmter Zeitgebertakt mit der Frequenz f_{T} zugeführt. Dieser Zeitgebertakt f_{T} entspricht dem Takt, mit dem die in Fig. 1 gezeigte Priorisierungslogik 3 betrieben wird, und wird aus einem peripheren Taktsignal abgeleitet. Durch Setzen des Startbits ADxTR wird das Zeitgeberregister 10 mit in einem Bitfeld ADxTRLD eines Initialisierungsregisters 7 definierten Initialisierungswert geladen. Dieser Initialisierungswert entspricht einem Anfangszählerstand Nₘₐₓ des Zeitgeberregisters 10, der abhängig von dem Taktsignal f_{T} stufenweise verringert, d. h. dekrementiert wird. Die Dekrementierung des Zählerstands des Zeitgeberregisters 10 erfolgt solange, bis ein Unterlauf des Zeitgeberregisters 10 auftritt. Bei Feststellen eines Unterlaufs des Zeitgeberregisters 10 erfolgt eine Neuinitialisierung des Zeitgeberregisters 10, wobei über eine Einrichtung 9 der in dem Bitfeld ADxTRLD definierte Initialisierungs- bzw. Anfangswert erneut in das Zeitgeberregister 10 geladen wird.

Gemäß dem in Fig. 2 gezeigten bevorzugten Ausführungsbeispiel des erfindungsgemäßen Zeitgebers 1b werden von dem Zeitgeber nicht nur Anforderungssignale für eine A/D-Wandlung durch den in Fig. 1 dargestellten A/D-Wandler 5 erzeugt, sondern der Zeitgeber 1b dient auch zur Erzeugung bestimmter ServiceAnfragen, die von entsprechenden Service-Einrichtungen der jeweiligen Applikation auszuwerten sind. Zu diesem Zweck ist ein entsprechendes Register 13 vorgesehen, in dem bei Vorliegen eines Unterlaufs des Zeitgeberregisters 10 ein Steuerflag ADxSRT gesetzt wird, um auf diese Weise eine entsprechende Serviceanfragen auszulösen. In der Regel kann diese Servicefunktion applikationsspezifisch konfiguriert und aktiviert bzw. deaktiviert werden.

Um die Abtastung und A/D-Wandlung von dem Zeitgeber zugeordneten analogen Signalen ohne Jitter zu ermöglichen, ist ein weiteres Register 11 vorgesehen, in dem in Form eines Bitfelds ADxALB ein bestimmter Schwellen- bzw. Grenzwert N_{S} definiert ist, der einem Vergleicher 12 zugeführt wird. Das Register 11 kann frei programmiert werden, um den Schwellenwert N_{S} an die jeweiligen Bedürfnisse anzupassen. Der Vergleicher 12 vergleicht den augenblicklichen Zählerstand N bzw. Inhalt des Zeitgeberregisters 10 mit dem durch das Register 11 vorgegeben Schwellenwert N_{S}. Sobald der Vergleicher 12 erkannt hat, daß der Inhalt des Zeitgeberregisters 10 den vorgegebenen Schwellenwert N_{S} erreicht hat bzw. darunter abgesunken ist, wird ein Steuerbit ADxAL in einem weiteren Steuerregister 14 gesetzt. Wie nachfolgend noch näher erläutert wird, führt das gesetzte Steuerflag ADxAL unabhängig von dem eigentlichen Anforderungssignal des Zeitgebers 1b zur Erzeugung eines zusätzlichen Signals, um durch Kombination dieses zusätzlichen Signals mit dem eigentlichen Anforderungssignal des Zeitgebers 1b den in Fig. 1 gezeigten A/D-Wandler 5 für eine dem Schwellenwert N_{S} entsprechende programmierbare Zeitspanne für andere Wandlungsanfragen niederpriorer Anforderungsquellen zu blockieren und somit künstlich für den Zeitgeber 1b zu reservieren. Das in dem Steuerregister 14 gesetzte Steuerflag ADxAL wird jeweils bei Feststellen eines Unterlaufs des Zeitgeberregisters 10 zurückgesetzt, d. h. gelöscht.

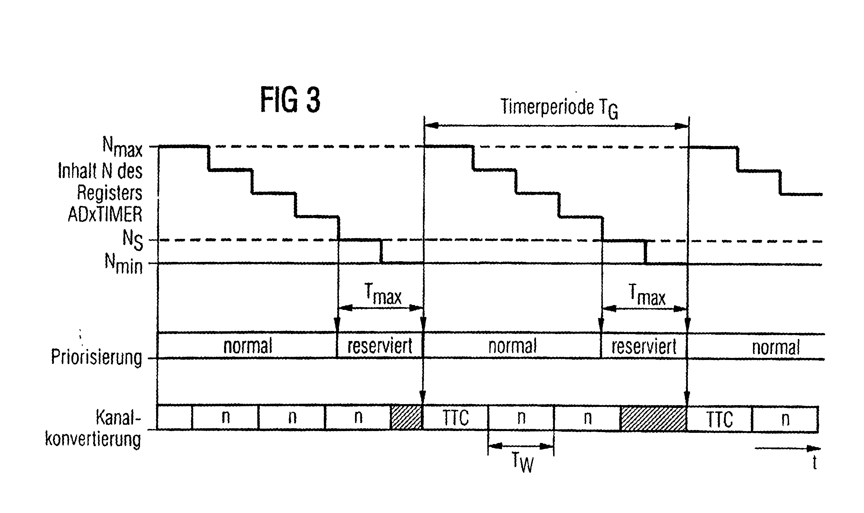

Die Funktion des in Fig. 2 dargestellten Schaltungsabschnitts soll nachfolgend näher anhand des in Fig. 3 dargestellten Zeitdiagramms erläutert werden.

Im oberen Bereich des in Fig. 3 dargestellten Diagramms ist der Verlauf des Zählerstands N des Zeitgeberregisters 10 (ADxTIMER) dargestellt. Das Zeitgeberregister 10 wird im Laufe einer Timer- bzw. Zeitgeberperiode T_{G} ausgehend von dem Initialisierungs- bzw. Anfangswert Nₘₐₓ entsprechend der Taktfrequenz f_{T} stufenweise dekrementiert, wobei bei Feststellen eines Unterlaufs des Zeitgeberregisters 10, d. h. bei Erreichen eines minimalen Zählerstands Nₘᵢₙ, die anhand Fig. 2 erläuterte neue Initialisierung erfolgt, wodurch der in dem Register 7 festgelegte Anfangswert Nₘₐₓ erneut in das Zeitgeberregister 10 geladen wird, so daß im Laufe der nachfolgenden Zeitgeberperiode T_{G} eine erneute Dekrementierung des Zeitgeberinhalts möglich ist. Die Zeitgeberperiode T_{G} kann zwischen einigen µs und einigen ms betragen und wird derart festgelegt, daß eine zeitgeberbasierende Auslösung von Serviceanforderungen sowie A/D-Wandleranforderungen für die dem Zeitgeber zugeordneten Signalkanäle möglich ist. Wie nachfolgend noch näher erläutert wird, führt ein Unterlauf des Zeitgeberregisters 10 nicht nur zu einer Neuinitialisierung des Zeitgeberregisters 10 und dem Setzen des Steuerflags ADxSRT in dem Steuerregister 13 (vergl. Fig. 2), sondern auch zum Erzeugen eines neuen Triggerimpulses für das von dem Zeitgeber 1b bekannterweise ausgegebene Anforderungssignal.

Fig. 4 zeigt ein Blockschaltbild eines weiteren Abschnitts des Zeitgebers 1b gemäß dem bevorzugten Ausführungsbeispiel der vorliegenden Erfindung, mit dessen Hilfe die Erzeugung des gewöhnlichen Anforderungssignals durch den Zeitgeber 1b für den A/D-Wandler 5 (vergl. Fig. 1) erläutert werden soll.

Wie Fig. 4 entnommen werden kann, umfaßt der Zeitgeber 1b ein Triggersteuerregister 16, welches zusammen mit einem weiteren Register 17 zur Erzeugung eines Triggerimpulses für ein neues Anforderungssignal des Zeitgebers 1b dient. Das Triggersteuerregister (ADxTTC) umfaßt 16 Steuerbits, die jeweils einem Signalkanal des Zeitgebers zugeordnet sind. Durch Setzen eines Steuerbits dieses Registers 16 wird eine Triggerung des dem jeweiligen Steuerbit entsprechenden Signalkanals des Zeitgebers 1b ermöglicht. Bei Auftreten eines entsprechenden Triggerimpulses wird ein entsprechendes Flag in einem weiteren Register 17 gesetzt, wobei dieses Register 17 (ADxTCRP) wiedergibt, für welche Signalkanäle augenblicklich eine Wandlungsanforderung vorliegt. Auf diese Weise können Wandlungsanforderungen mehrerer Signalkanäle gleichzeitig getriggert werden. Die in dem Register 17 in Übereinstimmung mit der Konfiguration des Triggersteuerregisters 16 bei einem Unterlauf des Zeitgeberregisters 10 gesetzten Flags werden über eine logische ODER-Schaltung 18 miteinander verknüpft, wobei das Ausgangssignal der ODER-Schaltung den Zustand des in dem Register 15b abgespeicherten Steuerflags entspricht, welches - wie bereits anhand Fig. 1 erläutert worden ist - von der ebenfalls in Fig. 1 gezeigten Priorisierungslogik 3 ausgewertet wird. Durch die ODER-Verknüpfung der Steuerflags des Registers 17 ist gewährleistet, daß von dem Zeitgeber 1b ein den Zustand des gesetzten Steuerflags im Register 15b entsprechendes Anforderungssignal 20 für den A/D-Wandler erzeugt wird.

Wie bereits anhand Fig. 1 erläutert worden ist, überwacht die Priorisierungslogik 3 den Zustand der Steuerflags der Register 15a - 15c der einzelnen verfügbaren Anforderungsquellen 1a - 1c und führt die zuvor erwähnte Priorisierung bzw. Arbitrierung durch, falls mindestens ein Flag 15a - 15c einer Anforderungsquelle 1a - 1c gesetzt ist. Weist der Zeitgeber 1b ein in dem Register 15b gesetztes Steuerflag auf, wird entsprechend die von dem Zeitgeber 1b erzeugte Anforderung für den A/D-Wandler 5 von der Priorisierungslogik 3 berücksichtigt und die Anforderung des Zeitgebers 1b von der Priorisierungslogik ausgewählt, falls nicht gleichzeitig eine Anforderung einer höherprioren Anforderungsquelle vorliegt. Ist dies der Fall, wird über den in Fig. 1 gezeigten Multiplexer 2 der Zeitgeber 1b als zu verarbeitende Anforderungsquelle ausgewählt. Mit Hilfe der ebenfalls in Fig. 1 gezeigten Kanalpriorisierungslogik 4 wird anschließend der innerhalb des Zeitgebers 1b zu wandelnde Signalkanal bestimmt. Dies erfolgt dadurch, daß die in dem Register 17 enthaltenen Steuerflags von der Kanalpriorisierungslogik 4 überwacht und ausgewertet werden, wobei die Kanalpriorisierungslogik 4 das in dem Register 17 gesetzte Flag der höchsten Wertigkeit erfaßt und den entsprechenden Signalkanal des Zeitgebers 1b dem A/D-Wandler 5 zur A/D-Wandlung zuführt. Nachdem die A/D-Wandlung für den von der Kanalpriorisierung 4 ausgewählte Signalkanal angereizt worden ist, wird das dem Signalkanal entsprechende Steuerflag in dem Register 17 wieder gelöscht.

Wie Fig. 4 entnommen werden kann, überwacht die Priorisierungslogik 3 jedoch nicht nur den Zustand des Steuerregisters 15b, sondern auch über eine weiter ODER-Schaltung 19 den Zustand des bereits anhand Fig. 2 erläuterten Steuerregisters 14, in dem durch den Vergleicher 12 das Steuerflag ADxAL bei Erreichen und Unterschreiten des vorgegebenen Schwellenwerts N_{S} gesetzt wird. Dies führt dazu, daß von dem Zeitgeber 1b bzw. der ODER-Schaltung 19 nicht nur dann ein Anforderungssignal für den A/D-Wandler 5 erzeugt wird, wenn mindestens eines der Steuerflags des Registers 17 besetzt ist, sondern insbesondere stets dann, wenn das in dem Register 14 vorhandene Steuerflag ADxAL gesetzt ist, d. h. der Inhalt des Zeitgeberregisters 10 unter den vorgegebenen Schwellenwert N_{S} abgefallen ist. In diesem Fall wird über das Register 14 ein "künstliches" bzw. zusätzliches Anforderungssignal an die ODER-Schaltung 19 angelegt und somit der Einfluß des Ausgangssignals der ODER-Schaltung 18 bzw. des Registers 15b deaktiviert. Wie in Fig. 3 gezeigt ist, wird das Steuerflag ADxAL zu einem bestimmten Zeitpunkt Tₘₐₓ vor Ende der Zeitgeberperiode T_{G} gesetzt. Dieser Zeitpunkt Tₘₐₓ hängt von dem vorgegebenen Schwellenwert N_{S} ab und sollte derart dimensioniert sein, daß die Zeitspanne Tₘₐₓ mindestens solange wie die von dem A/D-Wandler 5 für eine A/D-Wandlung eines Abtastwerts benötigte Zeitdauer ist. Ist beispielsweise dem Zeitgeber 1b die höchste Priorität für die Funktion der Priorisierungslogik 3 (vergl. Fig. 1 und 4) zugeordnet, kann auf diese Weise sichergestellt werden, daß bei A/D-Wandlung des letzten Abtastwerts eines dem Zeitgeber 1b zugeordneten analogen Signals nicht mit einer neuen A/D-Wandlung begonnen wird, ehe der letzte A/D-Wandlungsvorgang abgeschlossen ist.

Wie in Fig. 3 gezeigt ist, erfolgt aufgrund des Einflusses des in Fig. 4 dargestellten Steuerflags ADxAL nur dann eine "normale" Priorisierung durch Auswertung des Zustands des Steuerregisters 15b des Zeitgebers 1b, wenn der Inhalt des Zeitgeberregisters 10 noch nicht den Schwellenwert N_{S} erreicht hat. Sobald hingegen der Inhalt des Zeitgeberregisters 10 auf den Schwellenwert N_{S} bzw. darunter abgesunken ist, wird über das zusätzlich erzeugte Signal 21 des Steuerregisters 14, welches von dem Zustand des Steuerflags ADxAL abhängt, künstlich in den Arbitrierungs- bzw. Priorisierungsablauf der Priorisierungslogik 3 eingegriffen und auf diese Weise der A/D-Wandler 5 für die programmierbare Zeitspanne Tₘₐₓ für andere, niederpriore Anforderungsquellen blockiert bzw. für den Zeitgeber 1b reserviert. Sobald ein Unterlauf des Zeitgeberregisters 10 auftritt, wird das Steuerflag ADxAL wieder gelöscht und das Zeitgeberregister 10 erneut mit dem Initialisierungswert Nₘₐₓ belegt, so daß wieder eine "normale" Auswertung des Ausgangssignals der in Fig. 4 gezeigten ODER-Schaltung 18 bzw. des Steuerregisters 15b vorerst ohne Einfluß des Steuerflags ADxAL möglich ist.

Im unteren Bereich des in Fig. 3 gezeigten Diagramms ist ergänzend der Ablauf der Kanalkonvertierung dargestellt, wobei davon ausgegangen wird, daß der Zeitgeber 1b von der Priorisierungslogik 3 als höchstpriore Anforderungsquelle für den A/D-Wandler 5 ausgewählt worden ist. Dabei ist aus Fig. 3 ersichtlich, daß während einer Phase die zuvor erwähnte Triggerung erfolgt (Timer Triggered Conversion, TTC), um den zu wandelnden Signalkanal oder die zu wandelnden Signalkanäle des Zeitgebers 1b zu ermitteln. Anschließend wird während mehrerer Taktzyklen der ausgewählte Signalkanal n=0...15 des Zeitgebers 1b abgetastet und von dem A/D-Wandler 5 gewandelt. Dabei bezeichnet in Fig. 3 T_{W} die von dem A/D-Wandler 5 zur Wandlung eines Abtastwerts benötigte Wandlungszeit. Ergänzend ist im unteren Bereich von Fig. 3 derjenige Zeitabschnitt schraffiert dargestellt, während dessen der A/D-Wandler 5 nach Wandlung des letzten Abtastwerts durch das im Register 14 gesetzte Steuerflag ADxAL für den Zeitgeber reserviert ist und auf einen neuen Abtastwert eines neuen Signalkanals (gegebenenfalls nach Auswahl einer neuen Anforderungsquelle durch die Priorisierungslogik 3) wartet.

Abschließend sei darauf hingewiesen, daß anstelle der zuvor erläuterten Realisierung eines stufenweise dekrementierten Registers 10 selbstverständlich die Anordnung auch dahingehend abgewandelt werden kann, daß das Zeitgeberregister 10 stufenweise ausgehend von Nₘᵢₙ inkrementiert wird, wobei in diesem Fall der Schwellenwert N₅ auf den maximalen Registerinhalt Nₘₐₓ bezogen festzulegen ist, um die Zeitspanne Tₘₐₓ zu definieren. Die zuvor erläuterte Realisierung eines stufenweise dekrementierten Zeitgeberregisters 10 ist jedoch technisch einfacher zu realisieren.

## Patentansprüche

1. Zeitgeber für einen A/D-Wandler,
mit Anforderungssignal-Erzeugungsmitteln (7-21), um während einer sich periodisch wiederholenden bestimmten Zeitspanne (T_{G}) ein erstes Anforderungssignal (20) für eine A/D-Wandlung eines dem Zeitgeber (1b) zugeordneten analogen Signals durch den A/D-Wandler (5) zu erzeugen,
**dadurch gekennzeichnet,**
**daß** die Anforderungssignal-Erzeugungsmittel (7-21) derart ausgestaltet sind, daß sie ab einem gewissen Zeitpunkt (Tₘₐₓ) vor Ablauf der bestimmten Zeitspanne (T_{G}) und bis zum Ende der bestimmten Zeitspanne T_{G} ein zweites Anforderungssignal (21) erzeugen, welches in Kombination mit dem ersten Anforderungssignal (20) für eine A/D-Wandlung durch den A/D-Wandler (5) auszuwerten ist.

2. Zeitgeber nach Anspruch 1
**dadurch gekennzeichnet,**
**daß** die Anforderungssignal-Erzeugungsmittel (7-21) ein Zeitgeberregister (10) umfassen, dessen Inhalt während der sich periodisch wiederholenden bestimmten Zeitspanne (T_{G}) ausgehend von einem bestimmten Initialisierungswert (Nₘₐₓ) stufenweise auf einen bestimmten Minimalwert (Nₘᵢₙ) verringert wird, und
**daß** die Anforderungssignal-Erzeugungsmittel (7-21) einen Vergleicher (12) zum Überwachen des Inhalts des Zeitgeberregisters (10) umfassen, der die Erzeugung des zweiten Anforderungssignals (21) auslöst, falls der Inhalt des Zeitgeberregisters (10) unter einem bestimmten Schwellenwert (N_{S}) abgesunken ist.

3. Zeitgeber nach Anspruch 2,
**dadurch gekennzeichnet,**
**daß** die Anforderungssignal-Erzeugungsmittel (7-21) ein programmierbares Schwellenwertregister (11) umfassen, welches mit dem Vergleicher (12) gekoppelt ist und dessen Inhalt den bestimmten Schwellenwert (N_{S}) und somit den bestimmten Zeitpunkt (Tₘₐₓ) für die Erzeugung des zweiten Anforderungssignals (21) definiert.

4. Zeitgeber nach Anspruch 2 oder 3,
**dadurch gekennzeichnet,**
**daß** dem Zeitgeber (1b) mehrere Kanäle zugeordnet sind, die jeweils analoge Signale für den A/D-Wandler (5) bereitstellen, und
**daß** die Anforderungssignal-Erzeugungsmittel (7-21) ein Triggerregister (16, 17) mit den einzelnen Kanälen zugeordneten Steuerbits umfassen, wobei an das Triggerregister (16, 17) ein Triggerimpuls angelegt wird, falls der Inhalt des Zeitgeberregisters (10) dem bestimmten Minimalwert (Nₘᵢₙ) erreicht hat und
wobei durch Anlegen des Triggerimpulses ein bestimmtes Steuerbit des Triggerregisters (16, 17) gesetzt und **dadurch** der dem gesetzten Steuerbit entsprechende Kanal für eine A/D-Wandlung durch den A/D-Wandler (5) ausgewählt wird.

5. Zeitgeber nach Anspruch 4,
**dadurch gekennzeichnet,**
**daß** die Anforderungssignal-Erzeugungsmittel (7-21) eine ODER-Schaltung (18) umfassen, welche als Eingangssignale die Zustände der Steuerbits des Triggerregisters (16, 17) empfängt und als Ausgangssignal das erste Anfangssignal (20) bereitstellt.

6. Zeitgeber nach einem der Ansprüche 2 - 5,
**dadurch gekennzeichnet,**
**daß** die Anforderungssignal-Erzeugungsmittel (7-21) ein weiteres Register (14) umfassen, in dem von dem Vergleicher (12) ein den Zustand des zweiten Anforderungssignals (21) bestimmendes Steuerbit gesetzt wird, und
**daß** eine weitere ODER-Schaltung (19) vorgesehen ist, welche als Eingangssignale den Zustand des von dem Vergleicher (12) angesteuerten Steuerbits des weiteren Registers (14) und das erste Anforderungssignal (20) empfängt, und dessen Ausgangssignal für die A/D-Wandlung durch den A/D-Wandler (5) auszuwerten ist.

7. Zeitgeber nach Anspruch 6,
**dadurch gekennzeichnet,**
**daß** die Anforderungssignal-Erzeugungsmittel (7-21) Initialisierungsmittel (7, 9) umfassen, welche das Zeitgeberregister (10) erneut mit dem bestimmten Initialisierungswert (Nₘₐₓ) belegen und das von dem Vergleicher (12) gesetzte Steuerbit des weiteren Registers (14) löschen, falls der Inhalt des Zeitgeberregisters (10) auf den bestimmten Minimalwert (nₘᵢₙ) abgesunken ist.

8. Zeitgeber nach Anspruch 6 oder 7,
**dadurch gekennzeichnet,**
**daß** der Zeitgeber (1b) eine von mehreren Anforderungseinrichtungen (1a - 1c) für den A/D-Wandler (5) darstellt, wobei die Anforderungseinrichtungen (1a - 1c) Anforderungssignale für eine A/D-Wandlung eines der jeweiligen Anforderungseinrichtung (1a - 1c) zugeordneten analogen Signals erzeugen, und
**daß** das Ausgangssignal der weiteren ODER-Schaltung (19) Steuermitteln (3) zugeführt ist, welche abhängig von den Anforderungssignalen der einzelnen Anforderungseinrichtungen (1a - 1c) eine der Anforderungseinrichtungen (1a - 1c) für die A/D-Wandlung durch den A/D-Wandler (5) auswählen.

9. Zeitgeber nach Anspruch 8,
**dadurch gekennzeichnet,**
**daß** jeder Anforderungseinrichtung (1a - 1c) eine bestimmte Priorität zugeordnet ist, und
**daß** die Steuermittel (3) derart ausgestaltet sind, daß sie bei gleichzeitigem Anliegen von Anforderungssignalen unterschiedlicher Anforderungseinrichtungen (1a - 1c) daraus diejenige Anforderungseinrichtung für die A/D-Wandlung des A/D-Wandlers (5) auswählen, der die höchste Priorität zugeordnet ist.

10. Zeitgeber nach Anspruch 9,
**dadurch gekennzeichnet,**
**daß** dem Zeitgeber (1b) die höchste Priorität zugeordnet ist.

## Claims

1. Timer for an A/D converter, having request signal generation means (7-21) in order to generate a first request signal (20) for an A/D conversion of an analogue signal assigned to the timer (1b) by the A/D converter (5) during a periodically repeating, specific time span (T_{G}), **characterized in that** the request signal generation means (7-21) are designed such that they generate a second request signal (21) from a certain point in time (Tₘₐₓ) on before the specific time span (T_{G}) expires and up to the end of the specific time span (T_{G}), which second request signal (21) is to be evaluated in combination with the first request signal (20) for an A/D conversion by the A/D converter (5).

2. Timer according to Claim 1, **characterized in that** the request signal generation means (7-21) comprise a timer register (10), whose content is reduced in stepped fashion, starting from a specific initialization value (Nₘₐₓ), to a specific minimum value (Nₘᵢₙ) during the periodically repeating, specific time span (T_{G}), and **in that** the request signal generation means (7-21) comprise a comparator (12) for the purpose of monitoring the content of the timer register (10), which triggers the generation of the second request signal (21) if the content of the timer register (10) has fallen below a specific threshold value (N_{S}).

3. Timer according to Claim 2, **characterized in that** the request signal generation means (7-21) comprise a programmable threshold value register (11), which is coupled to the comparator (12) and whose content defines the specific threshold value (N_{S}) and thus the specific point in time (Tₘₐₓ) for the generation of the second request signal (21).

4. Timer according to Claim 2 or 3, **characterized in that** a plurality of channels are assigned to the timer (1b) and each provide analogue signals for the A/D converter (5), and **in that** the request signal generation means (7-21) comprise a trigger register (16, 17) having control bits assigned to the individual channels, a trigger pulse being applied to the trigger register (16, 17) if the content of the timer register (10) has reached the specific minimum value (Nₘᵢₙ), and a specific control bit of the trigger register (16, 17) being set by the trigger pulse being applied and, as a result, the channel corresponding to the set control bit being selected for an A/D conversion by the A/D converter (5).

5. Timer according to Claim 4, **characterized in that** the request signal generation means (7-21) comprise an OR circuit (18), which receives the states of the control bits of the trigger register (16, 17) as input signals and provides the first request signal (20) as the output signal.

6. Timer according to one of Claims 2 - 5, **characterized in that** the request signal generation means (7-21) comprise a further register (14), in which a control bit which determines the state of the second request signal (21) is set by the comparator (12), and **in that** a further OR circuit (19) is provided, which receives the state of the control bit, which is driven by the comparator (12), of the further register (14) and the first request signal (20) as input signals, and whose output signal is to be evaluated for the A/D conversion by the A/D converter (5).

7. Timer according to Claim 6, **characterized in that** the request signal generation means (7-21) comprise initialization means (7, 9), which assign the specific initialization value (Nₘₐₓ) to the timer register (10) again and delete the control bit, which is set by the comparator (12), of the further register (14) if the content of the timer register (10) has fallen to the specific minimum value (Nₘᵢₙ).

8. Timer according to Claim 6 or 7, **characterized in that** the timer (1b) represents one of a plurality of request devices (1a - 1c) for the A/D converter (5), the request devices (1a - 1c) generating request signals for an A/D conversion of an analogue signal assigned to the respective request device (1a - 1c), and **in that** the output signal from the further OR circuit (19) is fed to control means (3), which select one of the request devices (1a - 1c) for the A/D conversion by the A/D converter (5) as a function of the request signals from the individual request devices (1a - 1c).

9. Timer according to Claim 8, **characterized in that** each request device (1a - 1c) is assigned a specific priority, and **in that** the control means (3) are designed such that, when request signals from different request devices (1a - 1c) are applied simultaneously, they select, from these devices, that request device for the A/D conversion of the A/D converter (5) which is assigned the highest priority.

10. Timer according to Claim 9, **characterized in that** the highest priority is assigned to the timer (1b).

## Revendications

1. Générateur d'horloge pour un convertisseur A/N comprenant des moyens de génération de signal de demande (7-21) pour générer, pendant un intervalle de temps (T_{G}) donné qui se répète périodiquement, un premier signal de demande (20) pour une conversion A/N par le convertisseur A/N (5) d'un signal analogique affecté au générateur d'horloge (1b), **caractérisé en ce que** les moyens de génération de signal de demande (7-21) sont configurés de telle sorte qu'ils génèrent, à partir d'un instant donné (Tₘₐₓ) avant l'écoulement de l'intervalle donné (T_{G}) et jusqu'à la fin de l'intervalle donné T_{G}, un deuxième signal de demande (21) qui doit être interprété pour une conversion A/N par le convertisseur A/N (5) en combinaison avec le premier signal de demande (20).

2. Générateur d'horloge selon la revendication 1, **caractérisé en ce que** les moyens de génération de signal de demande (7-21) comprennent un registre de générateur d'horloge (10) dont le contenu est réduit par paliers pendant l'intervalle de temps (T_{G}) donné qui se répète périodiquement en partant d'une valeur d'initialisation donné (Nₘₐₓ) jusqu'à une valeur minimale donnée (Nₘᵢₙ) et que les moyens de génération de signal de demande (7-21) comprennent un comparateur (12) pour surveiller le contenu du registre de générateur d'horloge (10), lequel déclenche la génération du deuxième signal de demande (21) si le contenu du registre de générateur d'horloge (10) est devenu inférieur à une valeur de seuil donnée (Ns).

3. Générateur d'horloge selon la revendication 2, **caractérisé en ce que** les moyens de génération de signal de demande (7-21) comprennent un registre de valeur de seuil programmable (11) qui est connecté au comparateur (12) et dont le contenu définit la valeur de seuil donnée (Ns) et ainsi l'instant donné (Tₘₐₓ) pour la génération du deuxième signal de demande (21).

4. Générateur d'horloge selon la revendication 2 ou 3, **caractérisé en ce que** plusieurs canaux sont associés au générateur d'horloge (1b), lesquelles fournissent à chaque fois des signaux analogiques pour le convertisseur A/N (5) et que les moyens de génération de signal de demande (7-21) comprennent un registre de déclenchement (16, 17) avec les bits de commande associés aux canaux individuels, une impulsion de déclenchement étant appliquée au registre de déclenchement (16, 17) si le contenu du registre de générateur d'horloge (10) a atteint la valeur minimale donnée (Nₘᵢₙ) et l'application de l'impulsion de déclenchement mettant à 1 un bit de commande donné du registre de déclenchement (16, 17), ce qui sélectionne le canal correspondant au bit de commande mis à 1 pour une conversion A/N par le convertisseur A/N (5).

5. Générateur d'horloge selon la revendication 4, **caractérisé en ce que** les moyens de génération de signal de demande (7-21) comprennent un circuit OU (18) qui reçoit comme signaux d'entrée des états des bits de commande du registre de déclenchement (16, 17) et fournit comme signal de sortie le premier signal de départ (20).

6. Générateur d'horloge selon l'une des revendications 2 à 5, **caractérisé en ce que** les moyens de génération de signal de demande (7-21) comprennent un registre supplémentaire (14) dans lequel est mis à 1 par le comparateur (12) un bit de commande qui détermine l'état du deuxième signal de demande (21) et qu'il est prévu un autre circuit OU (19) qui reçoit comme signaux d'entrée l'état du bit de commande du registre supplémentaire (14) commandé par le comparateur (12) ainsi que le premier signal de demande (20) et dont le signal de sortie est à interpréter pour la conversion A/N par le convertisseur A/N (5).

7. Générateur d'horloge selon la revendication 6, **caractérisé en ce que** les moyens de génération de signal de demande (7-21) comprennent des moyens d'initialisation (7, 9) qui affectent de nouveau au registre de générateur d'horloge (10) la valeur d'initialisation donnée (Nₘₐₓ) et effacent le bit de commande du registre supplémentaire (14), mis à 1 par le comparateur (12), si le contenu du registre de générateur d'horloge (10) a chuté à la valeur minimale donnée (nₘᵢₙ).

8. Générateur d'horloge selon la revendication 6 ou 7, **caractérisé en ce que** le générateur d'horloge (1b) représente pour le convertisseur A/N (5) un dispositif de demande parmi plusieurs (1a - 1c), les dispositifs de demande (1a - 1c) générant des signaux de demande en vue d'une conversion A/N d'un signal analogique affecté au dispositif de demande correspondant (1a - 1c) et que le signal de sortie de l'autre circuit OU (19) est acheminé à des moyens de commande (3) qui sélectionnent en fonction des signaux de demande des dispositifs de demande (1a - 1c) l'un des dispositifs de demande (1a - 1c) pour la conversion A/N par le convertisseur A/N (5) .

9. Générateur d'horloge selon la revendication 8, **caractérisé en ce qu'**une priorité donnée est affectée à chaque dispositif de demande (1a - 1c) et que les moyens de commande (3) sont configurés de telle sorte qu'en cas de présence simultanée des signaux de demande de différents dispositifs de demande (1a - 1c), ils sélectionnent parmi ceux-ci pour la conversion A/N par le convertisseur A/N (5) le dispositif de demande auquel est affectée la priorité la plus élevée.

10. Générateur d'horloge selon la revendication 9, **caractérisé en ce que** la priorité la plus élevée est affectée au générateur d'horloge (1b).
